# EUROPÄISCHE PATENTSCHRIFT

(11) **EP 4 323 777 B1**
(45) Veröffentlichungstag und Bekanntmachung des Hinweises auf die Patenterteilung: **29.01.2025**
(21) Anmeldenummer: 22723355.8
(22) Anmeldetag: 13.04.2022
(51) Int. Cl.: G01R 15/20, G01R 31/34, H02K 11/27, H02K 11/33, H02K 17/30

(54) **PHASENANSCHLUSS FÜR ELEKTROMOTOREN ZUR PHASENSTROMMESSUNG**
PHASE CONNECTION FOR ELECTRIC MOTORS FOR MEASURING PHASE CURRENTS
RACCORDEMENT DE PHASE POUR MOTEURS ÉLECTRIQUES POUR LA MESURE DU COURANT DE PHASE

(30) Priorität: 16.04.2021 DE 102021203802
(43) Veröffentlichungstag der Anmeldung: 21.02.2024
(73) Patentinhaber: MOLABO GmbH, 85521 Ottobrunn (DE)
(72) Erfinder: BACHHEIBL, Florian, 85521 Ottobrunn (DE); ROSSNER, Stefan, 85521 Ottobrunn (DE)
(74) Vertreter: Bardehle Pagenberg Partnerschaft mbB Patentanwälte Rechtsanwälte
(86) Internationale Anmeldenummer: PCT/EP2022/059943
(87) Internationale Veröffentlichungsnummer: WO 2022/219078

(56) Entgegenhaltungen:
- EP-A1- 3 726 234
- WO-A1-2013/065849
- CN-A- 112 600 364

## Beschreibung

### Technisches Gebiet

Die vorliegende Erfindung betrifft das technische Gebiet von elektrischen Antrieben, die über Phasenanschlüsse einer elektrischen Maschine verfügen. An den Phasenanschlüssen liegt ein Strom zum Betrieb der elektrischen Maschine an, um die Phasen des elektrischen Antriebs mit Strom zu versorgen. Genauer bezieht sich die Erfindung auf elektrische Antriebe, die über einen hochintegrierten Aufbau verfügen, der durch die Integration von mindestens einem Elektromotor als auch mindestens einem Umrichter als Teil der elektrischen Antriebe charakterisiert ist.

### Stand der Technik

Es sind Antriebswechselrichter mit einem Wechselstromgenerator bekannt, wobei der Wechselstromgenerator einen Strom an ein Anschlussfeld liefert, das mit den Phasen eines Elektromotors, einer Stromleitung, einem Wechselstromsensor an einigen Phasen, die den Elektromotor versorgen, einem Stromsensor an der Stromleitung, einem Eingang zum Empfangen von Informationen, die mindestens einen Wert eines Grenzstroms von der Quelle und eine erforderliche Drehmomentrichtlinie umfassen, und einer Steuerung verbunden ist, die die Phasenströme des Elektromotors auf der Grundlage der Drehmomentrichtlinie ansteuert, während der Strom in der Stromleitung auf der Grundlage des Grenzstroms von der Quelle auf einem akzeptablen Wert gehalten wird. Dementsprechend kann der Stromquelle immer ein maximaler Strom auferlegt werden, ohne dass die Gefahr besteht, diese zu beschädigen (WO 2011/064095 A2).

Dabei ist es allerdings nötig, den Sensor an die Stromleitung anzuschließen und den Phasenstrom darüber abzugreifen. Dies erfordert stromführende Schaltungselemente zum Anschluss einerseits, als auch dazu geeignete bauliche Anordnungen des Sensors im Vergleich zur Stromleitung andererseits, was die Implementierung und Anordnung eines solchen Sensors in einem Antrieb baulich verkompliziert. Zudem ist für Messungen mittels eines solchen Sensors und zum Erzielen genauer Messergebnisse teure Messtechnik erforderlich, was die Kosten auch unabhängig vom komplizierten Aufbau weiter erhöht. Gerade bei Multiphasensystemen, wie aus WO 2011/064095 A2 bekannt, ist eine Vielzahl von Sensoren oder Messvorrichtungen notwendig, um die Ströme der Phasen zu messen. Damit trotz der Vielzahl von notwendigen Messvorrichtungen ein kompakter Aufbau ermöglicht werden kann, ist die Verwendung kleiner Sensoren und Schaltungselemente notwendig, welche jedoch mit der erforderlichen Messgenauigkeit besonders teuer sind. Darüber hinaus würde eine Messung über die Stromleitung, wie durch angeschlossene Shunt-Widerstände, zu Spannungsabfällen führen und somit zu Verlusten an diesen Schaltungselementen, was die Effizienz des Antriebs und Systems nachteilhaft reduzieren würde. Zuletzt ist die separate Ausführung des Umrichters als externe Einheit, die über Anschlussleitungen mit dem Motor verbunden werden muss, ein weiterer Aspekt, der den benötigten Bauraum und das Gesamtgewicht des Systems nachteilhaft erhöht.

Die EP 3 726 234 A1 beschreibt ein Verfahren zur Diagnose eines Elektromotors (10), der einen Rotor und einen Stator aufweist. Dabei ist ein Wechselrichter ausgangsseitig mit dem Elektromotor elektrisch verbunden. Zur Messung von Phasenströmen des Elektromotors umfasst der Wechselrichter Stromsensoreinrichtungen, die jeweils einer Phase des Elektromotors zugeordnet sind. Dabei weisen die Stromsensoreinrichtungen jeweils mindestens zwei Magnetfeldsensoren auf.

Die CN 112 600 364 A beschreibt eine Antriebseinheit für einen radialen Auslassanschluss mit einem Motor, der ein Motorgehäuse, einen Stator und einen Rotor aufweist. Die Antriebseinheit umfasst zudem eine Motorsteuerungseinrichtung, wobei die Motorsteuerungseinrichtung auf der radialen Seite des Motors angeordnet ist, wobei die Motorsteuerungseinrichtung ein Gehäuse und eine Schaltungseinrichtung umfasst, wobei das Gehäuse fest mit dem Motorgehäuse verbunden ist, wobei die Schaltungseinrichtung in dem Gehäuse vorgesehen ist, und eine dreiphasige Elektrodenanschlussanordnung umfasst. Zudem umfasst die Antriebseinheit eine Anschlussbaugruppe, wobei die elektrische Anschlussbaugruppe an jedem Ende mit einem elektrischen Steueranschlussende und einem Motoranschlussende versehen ist, wobei das elektrische Anschlussende in dem Gehäuse angeordnet ist und elektrisch mit der Dreiphasen-Elektrodenanschlussbaugruppe verbunden ist, und wobei das Motoranschlussende elektrisch mit dem Stator verbunden ist.

Die WO 2013/065849 A1 beschreibt eine Wechselrichtervorrichtung, die ein Sammelschienenmodul umfasst, das elektrisch mit einer Vielzahl von Schaltelementen verbunden ist, wobei eine Steuerplatine auf der der Vielzahl von Schaltelementen gegenüberliegenden Seite angeordnet ist, wobei das Sammelschienenmodul sandwichartig dazwischen angeordnet ist. Das Sammelschienenmodul ist zudem über einen Modulbefestigungsabschnitt, der in dem Sammelschienenmodul vorgesehen ist, an einem Wechselrichtergehäuse befestigt. Die Steuerplatine ist an einem Platinenbefestigungsabschnitt befestigt, der in dem Sammelschienenmodul vorgesehen ist.

Zudem ist aus der WO 2008/107773 A1 bekannt, Open Loop Sensoren mit Magnetkernen, die um die Stromleiter herum angeordnet werden, zu verwenden, um den Strom, der vom Stromleiter geführt wird, zu messen. Dabei ist der Sensor auf einer Leiterplatte angeordnet und der Magnetkern ist in Form einer Spule um eine Öffnung der Leiterplatte herum angeordnet. Durch die Öffnung der Leiterplatte und somit durch den Magnetkern bzw. die Spule verläuft der Stromleiter, dessen Strom gemessen wird. Auch diese Lösung ist jedoch nur sehr kompliziert implementierbar, da der Magnetkern bzw. die Spule so angeordnet werden muss, dass der gesamte Leiter, der den zu messenden Strom trägt, umfasst wird. Dies macht den Aufbau kompliziert und aufwändig, wodurch die Aufbaukosten erhöht werden. Zusätzlich sind die Kosten einer solchen Platine oder Leiterplatte deutlich höher als die einer Platine oder Leiterplatte ohne Öffnungen durch welche der zu messende Stromleiter hindurchgeführt werden muss. Das Hindurchführen des Leiters durch eine solche Platinenöffnung führt zudem zu unerwünschten EMV-Einflüssen. Das heißt die an die Platine oder Leiterplatte angeschlossenen elektronischen Bauteile würden durch die elektrischen oder elektromagnetischen Effekte des durch die Platine oder Leiterplatte hindurchgeführten Leiters in ihrer Funktion stark beeinträchtigt oder vollständig gestört werden, was die Anwendung eines solchen Messprinzips sehr erschwert oder unmöglich macht. Zudem sind die Kosten des Magnetkerns selbst sehr hoch, da solche Magnetkerne aus teuren hochmagnetischen Eisen mit sehr kleinen Hysteresen hergestellt werden müssen, um sinnvolle Messergebnisse zu erreichen. Des Weiteren weist diese Variante aufgrund des notwendigen Magnetkerns, der den Leiter umschließt, einen wesentlich höheren Platzbedarf auf, der in platzkritischen elektrischen Antrieben nicht vorhanden ist. Der Magnetkern führt außerdem nachteilhaft zu einem erhöhten Gewicht. Ferner ist auch in dieser Variante die Ankopplung des Magnetkerns an den Sensor auf der Leiterplatte mit entsprechendem baulichem Aufwand erforderlich.

Würde stattdessen kein Magnetkern, keine Spule oder kein anderweitiges, das Magnetfeld aufnehmende oder erkennende Element mit einem Magnetfeld-Sensor verwendet werden und würde man stattdessen lediglich einen magnetkernlosen Magnetfeld-Sensor verwenden, so entsteht ein Problem bei der Genauigkeit der Messergebnisse, weil der Abstand des Magnetfeld-Sensors zu dem Stromleiter, dessen Strom gemessen werden soll, einen sehr großen Einfluss auf das Messergebnis hat. Denn ein Magnetfeld-Sensor misst das ihn durchdringende magnetische Feld, woraus die Stromstärke des Stroms, den der Stromleiter führt, berechnet werden kann. Durch Bewegungen oder Vibrationen ändert sich der Abstand eines magnetkernlosen Magnetfeld-Sensors zum Stromleiter und somit auch die magnetische Flussdichte, die der magnetkernlose Magnetfeld-Sensor misst, weshalb selbst ohne Veränderung des zu messenden Stroms eine fehlerhafte Änderung des gemessenen Stroms festgestellt werden würde. Die Vibrationen oder Bewegungen führen somit zu Messfehlern. Dieses Problem ist dem Einsatz von Magnetfeld-Sensoren ohne magnetischen Kern eigen, da bei Magnetfeld-Sensoren mit einem magnetischen Kern eben dieser den gesamten Leiter umschließt, weshalb selbst bei Vibrationen oder Bewegungen in der Summe dennoch dasselbe magnetische Feld den Magnetkern durchdringt. Mit anderen Worten wird durch Magnetfeld-Sensoren mit Magnetkern nicht bloß wie bei magnetkernlosen Magnetfeld-Sensoren eine magnetische Flussdichte, sondern ein definierter magnetischer Fluss gemessen. Somit entsteht das hier geschilderte Problem von Messfehlern bei magnetkernbehafteten bzw. mit Spulen versehenen Magnetfeld-Sensoren nicht, da der gemessene magnetische Fluss bei ihnen stets definiert ist.

Im Zusammenhang mit dem Einsatz von magnetkernlosen Magnetfeld-Sensoren in einem elektrischen Antrieb ist der Einfluss des Abstands des Sensors zum zu messenden Stromleiter äußerst problematisch, weil ein elektrischer Antrieb einerseits durch die Bewegung des Rotors selbst Vibrationen verursacht und da ein elektrischer Antrieb, der in Fahrzeugen verwendet wird, andererseits auch den Bewegungen des Fahrzeugs ausgesetzt ist. Solche Bewegungen und Vibrationen führen dazu, dass auch der Magnetfeld-Sensor und der Stromleiter ständigen Bewegungen und Vibrationen ausgesetzt sind, was letztlich den Abstand des Magnetfeld-Sensors zum Stromleiter und somit auch das den Magnetfeld-Sensor durchdringende magnetische Feld ständig verändert. Dadurch entstehen von den Vibrationen und/oder Bewegungen verursachte Messungenauigkeiten, die die Genauigkeit des gemessenen Stromwertes abweichend vom tatsächlichen Strom negativ beeinflussen. Bei der Steuerung von elektrischen Antrieben ausgehend von einem falschen Stromwert, wird letztlich auch der elektrische Antrieb falsch gesteuert und betrieben, was den elektrischen Antrieb in der Praxis nicht effizient einsetzbar macht. Insbesondere würde darunter die Drehmomenttreue eines elektrischen Antriebs leiden.

Ein anderes Problem beim Einsatz von Magnetfeld-Sensoren ohne Magnetkern ist, dass Einflüsse anderer, externer, Magnetfelder nicht vom zu messenden Magnetfeld des Stromleiters, dessen Strom bestimmt werden soll, getrennt werden können. Denn bei Magnetfeld-Sensoren mit Magnetkern werden solche externen Magnetfelder durch den Kern unterdrückt. Gerade beim Einsatz in elektrischen Antrieben befinden sich jedoch eine Vielzahl von stromdurchflossenen Leitern, wie diejenigen von den mehreren Phasen des elektrischen Antriebs, in naher Umgebung zu dem zu messenden Stromleiter einer der Phasen, wodurch eine Vielzahl an störenden Magnetfeldern erzeugt werden. Auch hierdurch wird der gemessene Strom negativ beeinflusst und verfälscht.

Ein weiteres Problem bei der Verwendung von Magnetfeld-Sensoren ohne Magnetkern ist, dass die Flussdichte des Magnetfeldes, welches der Strom im zu messenden Stromleiter erzeugt und der den Magnetfeld-Sensor durchdringt, gering ist. Denn ein solcher Sensor befindet sich lediglich auf einer Seite ausgehend vom Stromleiter, wohingegen ein Magnetkern den gesamten Leiter umfasst und wobei durch einen Magnetkern die Flussdichte um einen Faktor, wie einem Faktor 100, verstärkt wird. Folglich kann durch den Wegfall der hohen Permeabilität ohne Magnetkern nur eine deutlich geringere Flussdichte am Sensor auftreten, weshalb die Empfindlichkeit und somit das Signal-Rausch-Verhältnis nachteilhaft gering ist, was die Messgenauigkeit weiter negativ beeinflusst.

Der im Patentanspruch 1 angegebenen Erfindung liegt das Problem zugrunde, die Nachteile der Verwendung von magnetkernlosen Magnetfeld-Stromsensoren im Einsatz in elektrischen Antrieben mit integrierter elektrischer Maschine und integriertem Umrichter, welche zum Betrieb eine genaue Strommessung der Phasenströme erfordern, zu minimieren. Mittels eines integrierten Umrichters kann eine an den hochintegrierten Antrieb angeschlossene Gleichstromquelle verwendet werden und die elektrische Maschine kann mit durch den integrierten Umrichter erzeugtem Wechselstrom versorgt werden, ohne dass es dazu weiteren Bauteilen oder Komponenten bedarf. Dies ist insbesondere im Bereich der Elektromobilität von großer Bedeutung, da in vielen elektrischen Fahrzeugen die elektrische Energie in Batteriespeichern gespeichert wird, welche ihrerseits keinen Wechselstrom, sondern Gleichstrom liefern. Dahingegen müssen viele Arten von Elektromotoren zum Betrieb mit Wechselstrom versorgt werden, um das gewünschte Wechselfeld in den Elektromotoren herbeizuführen, welches zur Bewegung des Rotors im Stator solcher Elektromotoren führt. Da ganz wesentliche Faktoren zum Bemessen der Effizienz von Elektrofahrzeugen deren Gewicht und die Leistungsdichte, die Größe und der somit erforderliche Bauraum der Antriebskomponenten der Elektrofahrzeuge darstellen, ist es ein wesentliches Ziel der vorliegenden Erfindung auch die Antriebskomponenten elektrischer Fahrzeuge zu verkleinern und dabei Gewicht zu sparen, während die Leistungsfähigkeit des Systems dennoch möglichst hoch ausfällt. Eine hohe Effizienz kann letztlich nur bei genauer Steuerung des Antriebs sichergestellt werden, weshalb ein Schwerpunkt der vorliegenden Erfindung auch auf der Verbesserung der Genauigkeit der Messergebnisse des Phasenstroms liegt.

Diese Probleme werden durch die im Patentanspruch 1 aufgeführten Merkmale gelöst. So umfasst der hochintegrierte elektrische Antrieb neben einem Umrichter eine elektrische Maschine. Mindestens ein Phasenanschluss eines Nutstabs der elektrischen Maschine ist außerhalb der Nut der entsprechenden Phase angeordnet. Zur Strommessung wird ein Messprinzip der Magnetfeldmessung genutzt, indem ein magnetkernloser Magnetfeld-Sensor an einer Krümmung im Phasenanschluss angeordnet ist.

Die mit der Erfindung erzielten Vorteile bestehen darin, dass anstatt magnetkernbehafteter Magnetfeld-Sensoren auch Magnetfeld-Sensoren ohne Magnetkern bzw. Spule zur Messung der Phasenströme verwendet werden können, ohne dabei die Messgenauigkeit von magnetkernbehafteten Magnetfeld-Sensoren zu verlieren. Des Weiteren vereinfacht die Verwendung magnetkernloser Magnetfeld-Sensoren zum einen den Aufbau, da solche Sensoren, anders als beispielsweise Shunt-Widerstände oder magnetkernbehaftete Magnetfeld-Sensoren, über keinerlei Schaltungselemente verfügen, die an den zu messenden Stromleiter gekoppelt werden müssen, oder die um den zu messenden Stromleiter herum angeordnet werden müssen. Dadurch erhöht sich die Systemeffizienz und der einfache Aufbau reduziert den Platzbedarf sowie die Herstellungskosten gegenüber herkömmlichen Lösungen deutlich. Trotz des Einsatzes von magnetkernlosen Magnetfeld-Sensoren wird eine hohe Messgenauigkeit erreicht, weil die Messung durch den Sensor an einer Krümmung des Leiters, dessen Strom gemessen werden soll, vorgenommen wird. Die Krümmung führt zur Fokussierung des Magnetfeldes bei dem Sensor, weshalb das Magnetfeld, das den magnetkernlosen Magnetfeld-Sensor durchdringt, deutlich stärker ausfällt, was die Messgenauigkeit und das Signal-Rausch-Verhältnis vorteilhaft erhöht. Die Verwendung eines massiven Nutstabs, der in Form eines ebenso massiven Phasenanschlusses an den Umrichter angeschlossen wird, anstatt an einer Drahtwicklung mit herausgeführten Wicklungsenden, führt zu einer verbesserten Steifigkeit und Robustheit gegenüber Beschleunigungen, die auf den Nutstab und insbesondere den Phasenanschluss einwirken, sodass sich Vibrationen oder Bewegungen nur in geringem Ausmaß auf den Abstand zwischen dem Magnetfeld-Sensor und dem zu messenden Stromleiter, das heißt dem Phasenanschluss, auswirken. Dadurch werden negative Störeinflüsse auf das Messergebnis des magnetkernlosen Magnetfeld-Sensors verringert.

Vorteilhafte Ausgestaltungen der Erfindung sind in den Unteransprüchen angegeben.

In einer Ausführungsform umfasst ein elektrischer Antrieb einen Umrichter, eine elektrische Maschine, die eine Vielzahl von Phasenstromzweigen umfasst, wobei die elektrische Maschine und der Umrichter gemeinsam in einem Gehäuse angeordnet sind, und mindestens einen magnetkernlosen Magnetfeld-Sensor zum Messen eines Stroms von mindestens einem der Vielzahl von Phasenstromzweigen, wobei mindestens ein Phasenstromzweig der Vielzahl von Phasenstromzweigen einen Nutstab umfasst, der zumindest teilweise in einer Nut der elektrischen Maschine angeordnet ist und der außerhalb der Nut einen Phasenanschluss bildet, und wobei der Phasenanschluss eine Krümmung aufweist in deren Bereich der mindestens eine magnetkernlose Magnetfeld-Sensor angeordnet ist.

In einer Ausführungsform kann sich der Phasenanschluss zumindest teilweise in einer Ebene erstrecken, in der eine Normale der Rotationsachse verläuft. Mit anderen Worten in einer Ebene normal zur Rotationsachse. Die Rotationsachse ist eine Rotationsachse eines Rotors des elektrischen Antriebs.

In einer Ausführungsform kann der Phasenanschluss von der Richtung der Normalen innerhalb der Ebene normal zur Rotationsachse weg gekrümmt sein.

In einer Ausführungsform kann der mindestens eine magnetkernlose Magnetfeld-Sensor auf einer Platine angeordnet sein.

In einer Ausführungsform kann der mindestens eine magnetkernlose Magnetfeld-Sensor ausschließlich eine physische Verbindung aufweisen, die den mindestens einen magnetkernlosen Magnetfeld-Sensor mit der Platine verbindet. Dabei kann die eine physische Verbindung einen oder mehrere physische Kontakte umfassen, die den mindestens einen magnetkernlosen Magnetfeld-Sensor jedoch ausschließlich mit der Platine und nicht mit weiteren Komponenten oder Bauteilen, wie einem Magnetkern, verbindet.

In einer Ausführungsform kann der mindestens eine magnetkernlose Magnetfeld-Sensor aus einem oberflächenmontierten Bauteil bestehen, das als integrierte Schaltung in einem eigenen Gehäuse auf der Platine angeordnet ist.

In einer Ausführungsform kann der mindestens eine magnetkernlose Magnetfeld-Sensor aus einem bedrahteten Bauteil bestehen, das als integrierte Schaltung in einem eigenen Gehäuse auf der Platine angeordnet ist.

In einer Ausführungsform kann der Phasenanschluss zumindest teilweise parallel zu einer Ebene verlaufen, auf der die Platine angeordnet ist.

In einer Ausführungsform kann die Platine eine Platine zur Steuerung des Umrichters sein. In einer anderen Ausführungsform kann die Platine eine Platine zur Strommessung sein, die eine signalübertragende Verbindung zu einer Platine zur Steuerung des Umrichters aufweist. In dieser Ausführungsform ist der Sensor nicht auf der Platine zur Steuerung des Umrichters angeordnet und der Sensor kann mit der Platine zur Strommessung an einem beliebigen Ort des elektrischen Antriebs angeordnet werden.

In einer Ausführungsform kann der mindestens eine magnetkernlose Magnetfeld-Sensor ein Hall-Sensor und/oder eines von einem Closed-Loop-Sensor oder einem Open-Loop-Sensor und/oder eines von einem magnetoresistiven Sensor, einem anisotropen magnetoresistiven Effekt, AMR, Sensor, einem Riesenmagnetowiderstand, GMR, Sensor, einem magnetischen Tunnelwiderstand, TMR, Sensor oder einem colossal magnetic resistance, CMR, Sensor sein.

In einer Ausführungsform kann der Phasenanschluss einen flexiblen Abschnitt mit einer Krümmung aufweisen, der den Phasenanschluss mit dem Teil des Nutstabs verbindet, der zumindest teilweise in der Nut der elektrischen Maschine angeordnet ist. Der flexible Abschnitt kann mindestens in eine Richtung einer Rotationsachse eines Rotors der elektrischen Maschine mechanisch flexibel sein, um mechanische Spannungen, die zumindest in Richtung der Rotationsachse auftreten, ausgleichen zu können.

In einer Ausführungsform kann der mindestens eine magnetkernlose Magnetfeld-Sensor zum Messen des Stroms von mindestens einem der Vielzahl von Phasenstromzweigen bei dem flexiblen Abschnitt und im Bereich der Krümmung des flexiblen Abschnitts angeordnet sein.

In einer Ausführungsform kann der flexible Abschnitt orthogonal zur Richtung der Rotationsachse verlaufen, wobei die Krümmung des flexiblen Abschnitts eine U-Form aufweist.

In einer Ausführungsform kann ein O-Ring den Phasenanschluss umschließen und einen Raum, der sich um den Phasenanschluss herum befindet, in zwei Teilräume teilen und diese voneinander fluiddicht trennen.

In einer Ausführungsform kann mindestens einer der Teilräume mit einem Verguss gefüllt sein.

In einer Ausführungsform kann der Verguss thermisch leitend und elektrisch isolierend sein und der Verguss kann thermisch mit einem Lagerschild des elektrischen Antriebs gekoppelt sein. Stattdessen oder zusätzlich zu dem Lagerschild kann der Verguss thermisch mit einem Kühlkörper des elektrischen Antriebs gekoppelt sein.

In einer Ausführungsform kann der elektrische Antrieb zusätzlich einen Beschleunigungssensor umfassen.

In einer Ausführungsform kann der Umrichter eine Architektur mit mindestens drei Ebenen aufweisen, die orthogonal zu der Rotationsachse verlaufen und die in Richtung der Rotationsachse zueinander versetzt angeordnet sind.

In einer Ausführungsform kann der Umrichter eine erste Ebene umfassen, wobei auf der ersten Ebene eine Platine zur Steuerung des Umrichters angeordnet ist.

In einer Ausführungsform kann der mindestens eine magnetkernlose Magnetfeld-Sensor auf der Platine zur Steuerung des Umrichters in der ersten Ebene angeordnet sein.

In einer Ausführungsform kann der Umrichter eine zweite Ebene aufweisen, wobei auf der zweiten Ebene mindestens ein Halbleiterbaustein des Umrichters angeordnet ist.

In einer Ausführungsform kann der Abschnitt des Phasenanschlusses, der sich zumindest teilweise in einer Ebene erstreckt, in der die Normale der Rotationsachse verläuft, auf der zweiten Ebene angeordnet sein.

In einer Ausführungsform kann der Umrichter eine dritte Ebene aufweisen, wobei auf der dritten Ebene mindestens ein Kühlkörper zur Kühlung der Halbleiterbausteine angeordnet ist.

In einer Ausführungsform kann die dritte Ebene einen Gleichstromanschluss mit einem Minuspol aufweisen, wobei die zweite Ebene einen Gleichspannungsanschluss mit einem Pluspol aufweist.

In einer Ausführungsform kann der Umrichter eine vierte Ebene aufweisen, wobei die vierte Ebene einen Gleichspannungsanschluss aufweist, der aus einem Pluspol und einem Minuspol besteht, wobei der Abschnitt des Phasenanschlusses, der sich zumindest teilweise in einer Ebene erstreckt, in der die Normale der Rotationsachse verläuft, auf der vierten Ebene angeordnet ist.

In einer Ausführungsform kann der Umrichter eine vierte Ebene aufweisen, wobei der Abschnitt des Phasenanschlusses, der sich zumindest teilweise in einer Ebene erstreckt, in der die Normale der Rotationsachse verläuft, auf der vierten Ebene angeordnet ist, und wobei die dritte Ebene einen Gleichspannungsanschluss mit einem Minuspol aufweist und wobei die zweite Ebene einen Gleichspannungsanschluss mit einem Pluspol aufweist.

Die vorhergehende Zusammenfassung dient dazu, einige Ausführungsformen zusammenzufassen, um ein grundlegendes Verständnis der Aspekte des hier beschriebenen Gegenstands zu vermitteln. Dementsprechend sollten die oben beschriebenen Merkmale nicht so ausgelegt werden, dass sie den Umfang des hier beschriebenen Gegenstands einschränken. Darüber hinaus können die obigen und/oder weiterführenden Ausführungsformen in jeder geeigneten Kombination kombiniert werden, um weitere Ausführungsformen bereitzustellen. Weitere Merkmale, Aspekte und Vorteile des hier beschriebenen Gegenstands werden aus der folgenden detaillierten Beschreibung, den Zeichnungen und den Ansprüchen ersichtlich.

### Zeichnungen

Um die Art und Weise zu beschreiben, in der die oben beschriebenen Ausführungsformen der Erfindung implementiert sind, sowie andere Vorteile und Merkmale der Offenbarung zu definieren, wird nachfolgend eine genauere Beschreibung zur Verfügung gestellt. In den beigefügten Zeichnungen werden Aspekte der Beschreibung dargestellt, wobei gleiche Ziffern gleiche Elemente bezeichnen. Mit dem Verständnis, dass diese Zeichnungen beispielhafte Ausführungsformen der Erfindung darstellen und daher nicht als im Umfang einschränkend zu betrachten sind, werden die Ausführungsformen mit zusätzlichen Details durch die Verwendung der beigefügten Zeichnungen im Folgenden näher erläutert.
Fig. 1 zeigt einen elektrischen Antrieb in einer perspektivischen Ansicht.
Fig. 2 zeigt einen Teil eines Stators eines elektrischen Antriebs mit einem Phasenanschluss in einer perspektivischen Ansicht.
Fig. 3 zeigt einen Teil eines Stators eines elektrischen Antriebs mit einem Phasenanschluss in einer perspektivischen Ansicht.
Fig. 4 zeigt einen Teil eines Umrichters eines elektrischen Antriebs mit einem Phasenanschluss in einer perspektivischen Ansicht.
Fig. 5 zeigt einen Teil eines Umrichters eines elektrischen Antriebs mit einem Phasenanschluss in einer perspektivischen Ansicht.

### Detaillierte Beschreibung

Es folgt die Erläuterung der Erfindung anhand der Zeichnungen nach Aufbau und Wirkungsweise der dargestellten Erfindung. Die vorliegende Offenbarung ist angesichts der folgenden Erläuterungen besser zu verstehen:
Unter einem Open-Loop-Sensor versteht man im Allgemeinen einen ein Magnetfeld-Sensor, auch als Hall-Effekt-Sensor bezeichnet, mit einem magnetischen Messwandler, um eine Spannung zu erzeugen, die proportional zu dem gemessenen Strom ist. Dieses Signal wird dann verstärkt, um ein analoges Ausgangssignal zu erzeugen, das proportional zu dem im Leiter fließenden Strom ist. Der Leiter wird durch die Mitte eines ferromagnetischen Kerns, auch als Magnetkern bezeichnet, geführt, um das Feld zu konzentrieren, und der magnetische Messwandler wird im Spalt des Kerns platziert.

Hingegen versteht man unter einem Closed-Loop-Sensor einen Magnetfeld-Sensor, der eine Spule umfasst, die von der Stromsensorschaltung aktiv angesteuert wird, um ein Magnetfeld zu erzeugen, das dem vom Strom im Leiter erzeugten Feld entgegengesetzt ist. Denn in einer open-loop Konfiguration kann jede Nichtlinearität oder Drift in der Empfindlichkeit des Magnetfeld-Stromsensor-ICs über die Temperatur zu Fehlern führen, was durch die Verwendung der aktiv angesteuerten Spule verhindert werden kann. Closed-loop-Stromsensoren mit geschlossenem Regelkreis benötigen also nicht nur ferromagnetische Kerne, sondern auch eine Spule und zusätzliche Verstärker höherer Leistung, um die Spule zu betreiben. Closed-loop-Sensoren sind aufgrund ihrer höheren Komplexität auch größer und verbrauchen mehr Strom, da sie die Kompensationsspule ansteuern müssen, und sind wegen der zusätzlichen Spule und der Ansteuerungsschaltung teurer. Die Effizienz des Systems wird durch solche Sensoren somit auch nachteilhaft reduziert.

Unter einem magnetkernlosen Magnetfeld-Sensor ist ein Sensor zu verstehen, der über keinen Magnetkern oder eine Spule verfügt, durch die ein Stromleiter, dessen Strom mit dem magnetkernlosen Magnetfeld-Sensor bestimmt werden soll, verläuft. Ein magnetkernloser Magnetfeld-Sensor kann demnach an, bei, das heißt im Bereich von, oder neben einem Stromleiter angeordnet werden, dessen Strom mit dem magnetkernlosen Magnetfeld-Sensor bestimmt werden soll. Dabei ergibt sich eine Grenze der freien Positionierbarkeit des Magnetfeld-Sensors an, bei oder neben dem Stromleiter dadurch, dass der magnetkernlose Magnetfeld-Sensor im Wirkbereich des Magnetfeldes, das sich um den stromführenden Stromleiter herum bildet, angeordnet sein muss. In einigen magnetkernlosen Magnetfeld-Sensoren muss der magnetische Fluss zudem senkrecht auf die Messfläche auftreten, in anderen, sogenannten 2D- oder 3D-Sensoren, kann jedoch der Vektor des magnetischen Flusses gemessen werden und bei diesen ist eine zum magnetischen Fluss senkrecht ausgerichtete Anordnung nicht erforderlich. Die vorliegende Erfindung ist diesbezüglich nicht eingeschränkt und die in der nachfolgenden Beschreibung umfassten Ausführungsbeispiele umfassen beide Varianten, da sowohl eine senkrechte als auch eine davon abweichende Anordnung und beide Arten von magnetkernlosen Magnetfeld-Sensoren umfasst sein können. Wenn diesen Erfordernissen nachgekommen wird, kann der magnetkernlose Magnetfeld-Sensor für die vorliegende Erfindung verwendet werden. Unter einem magnetkernlosen Magnetfeld-Sensor kann auch ein hallefektbasierter Sensor verstanden werden. Die Funktionsweise von Magnetfeld-Sensoren und deren Unterarten ist dem Fachmann bekannt, weshalb eine Beschreibung des genauen Aufbaus der Sensoren selbst vorliegend nicht vorgenommen wird und weshalb für die vorliegende Erfindung sämtliche Arten von Magnetfeld-Sensoren verwendet werden können.

Unter einem elektrischen Fahrzeug ist jedes Fahrzeug zu verstehen, das einen elektrischen Antrieb aufweist und das diesen zumindest teilweise, wie in Hybridfahrzeugen, oder allein, wie in Fahrzeugen mit ausschließlich einem oder mehreren elektrischen Antrieben, zum Antrieb des Fahrzeugs verwendet. So können Boote oder Schiffe, Kraftfahrzeuge wie Autos, Busse oder Lastkraftwagen, als auch Fluggeräte wie Flugzeuge, Drohnen oder Helikopter, Schienenfahrzeuge oder sonstige Fahrzeuge, die unter diese Kategorien fallen, aber auch Kleinfahrzeuge wie Elektroroller, Elektrofahrräder als elektrische Fahrzeuge verstanden werden. Diese Liste ist nicht als abschließende Beschreibung zu verstehen, sondern nennt lediglich beispielhafte Formen von Fahrzeugen, die, wenn sie über einen elektrischen Antrieb verfügen, als elektrische Fahrzeuge zu verstehen sind.

Unter einer elektrischen Maschine ist vorliegend eine elektrische Maschine zu verstehen, die hauptsächlich im motorischen Betrieb als Antrieb verwendet wird, die zudem aber auch im generatorischen Betrieb verwendet werden kann, wie zur Rekuperation von Energie. Eine elektrische Maschine kann alternativ auch als Motor bezeichnet werden und umfasst einen Rotor und einen Stator mit Nuten, wobei die Nuten des Stators nicht mit Wicklungen, die üblicherweise aus mehreren Windungen einer Drahtwicklung, wie einer Kupferdrahtwicklung, bestehen, gefüllt sind, sondern mit Stäben. Diese Stäbe sind massive Metallelemente, die die Nuten anders als übliche Drahtwicklungen nahezu vollständig ausfüllen. Unter nahezu vollständiger Ausfüllung ist zu verstehen, dass der Füllgrad in der Nut beispielsweise über 80%, oder zwischen 80 und 90%, oder über 90% beträgt. Ein Nutstab entspricht im technischen Sinne einer Wicklung mit einer Windungszahl gleich 1/2. Ein Nutstab ist gegenüber einer Drahtwicklung jedoch robuster und stabiler und ein Nutstab wird als massives Metallbauteil hergestellt, beispielsweise durch ein Extrusionsverfahren oder durch ein anderes hierfür geeignetes Verfahren wie ein Gussverfahren. Der Stab kann aus Aluminium oder jedem anderen leitenden Metall wie Kupfer, oder auch aus einem anderen elektrisch leitfähigen Material wie Graphit hergestellt sein. Damit ein solcher Nutstab oder ein aus der Nut herausgeführter Teil des Nutstabs, der einen Phasenanschluss darstellt, eine Krümmung aufweist, ist es erforderlich den Phasenanschluss des Nutstabs gezielt, beispielsweise mit einer entsprechend gekrümmten Gussform, oder mittels eines speziell hierfür geeigneten Biegeautomaten herzustellen. Somit ist unter einer Krümmung eine abschnittsweise Verformung bzw. Ausbildung des Phasenanschlusses zu verstehen, die von der einheitlichen, beispielsweise stab- oder zylinderförmigen Form des Phasenanschlusses abweicht und die nicht lediglich durch herkömmliches Wickeln oder anderweitiges Anordnen oder bloßes herkömmliches Biegen eines Drahtes einer Wicklung nach der Herstellung des Phasenanschlusses erzeugt werden kann, weil sich der massive und robuste Phasenanschluss nach dessen Herstellung nicht mehr ohne Weiteres in eine beliebige Form verbiegen oder entsprechend gekrümmt anordnen lässt. Zudem kann die Krümmung auch in Form einer Verjüngung des Phasenanschlusses ausgeführt sein.

Unter einer Platine, auch als Leiterplatte, gedruckte Schaltung, printed circuit board oder PCB bezeichnet, ist ein Träger für elektronische Bauteile zu verstehen, die der mechanischen Befestigung und elektrischen Verbindung dieser elektronischen Bauteile dient. Platinen bestehen aus einem elektrisch isolierenden Material auf dem elektrisch leitfähige Verbindungen, auch als Leiterbahnen bezeichnet, angebracht sind. Eine Platine kann auch mit mehreren Schichten gestaltet sein.

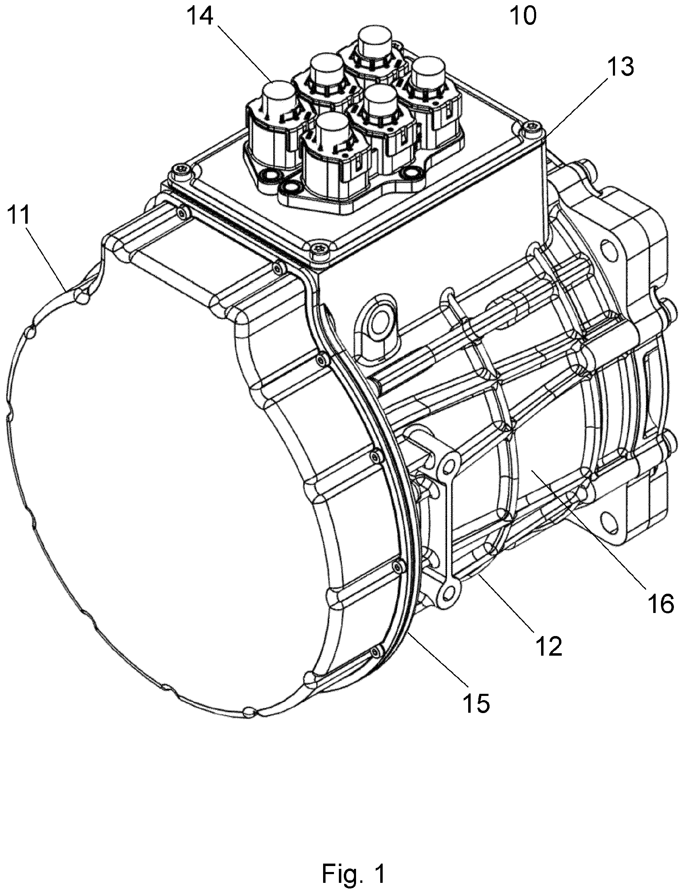

Fig. 1 zeigt einen elektrischen Antrieb 10 in einer perspektivischen Ansicht. Der elektrische Antrieb 10 umfasst einen Umrichter 11, der als ein integrierter Teil im elektrischen Antrieb 10 angeordnet ist. Es handelt sich somit um einen integrierten Umrichter, der im Gehäuse des elektrischen Antriebs 10 angeordnet ist. Die integrierte Anordnung des Umrichters ermöglicht es, dass der elektrische Antrieb 10 besonders kompakt gestaltet werden kann. Denn üblicherweise werden Umrichter als separate oder externe Vorrichtungen verwendet, sodass ein weiteres Gehäuse, Schaltungselemente und elektrische Kopplungselemente erforderlich wären, die ihrerseits allesamt Bauraum beanspruchen. Dies führt zu einem größeren Platzbedarf des Antriebssystems als auch zu einem höheren Systemgewicht. Beides ist nachteilhaft, insbesondere auch im Einsatz für elektrische Fahrzeuge jeder Art.

Der elektrische Antrieb 10 umfasst zudem eine elektrische Maschine 12, die eine in den elektrischen Antrieb 10 integrierte elektrische Maschine ist. Obwohl zur Vereinfachung der Beschreibung von einer elektrischen Maschine die Rede ist, kann der elektrische Antrieb 10 gemäß der vorliegenden Erfindung auch mehrere elektrische Maschinen umfassen und ist nicht auf eine elektrische Maschine beschränkt. Eine elektrische Maschine 12 umfasst zumindest einen Rotor und einen Stator. Im Stator sind Nuten vorgesehen durch welche Phasenstromzweige verlaufen. Die Phasenstromzweige dienen der Erzeugung eines magnetischen Feldes, das sich aufgrund des in den Phasenstromzweigen anliegenden Wechselstromes permanent ändert. Im Falle einer Asynchronmaschine werden durch die Änderung des Feldes im Rotor der elektrischen Maschine Spannungen induziert, die Ströme hervorrufen, was die Rotation des Rotors und somit die Bewegung der elektrischen Maschine bewirkt. Im Falle einer Synchronmaschine entsteht durch die Änderung des Feldes zwischen Rotor und Stator eine magnetische Energie, die das System durch Verdrehung des Rotors zu minimieren versucht. Die Funktionsweise einer elektrischen Maschine 12 ist dem Fachmann jedoch bekannt und wird an dieser Stelle deshalb nicht weitergehend beschrieben und die elektrische Maschine 12 ist weder auf eine Asynchronmaschine noch auf eine Synchronmaschine eingeschränkt, kann jedoch eine solche sein.

Der elektrische Antrieb 10 umfasst zudem eine Anschlussbox 13, welche auf dem Motormantel 16 eines Gehäuses 15 des elektrischen Antriebs 10 angeordnet ist. Der Motormantel 16 stellt dabei die Gehäusewand des Gehäuses 15 im Bereich der elektrischen Maschine 12 dar und der Motormantel 16 könnte auch als Maschinenmantel bezeichnet werden. Die Anschlussbox 13 dient dem Anschluss des elektrischen Antriebs 10 an eine oder mehrere externe Energiequellen, die in den Zeichnungen nicht dargestellt sind. Dazu werden Kabel 14, die von einer oder mehreren Gleichstromquellen, wie einer Batterie oder einem Batteriesystem eines elektrischen Fahrzeugs, ausgehen an die Anschlussbox 13 und die darin vorhandenen elektrischen Anschlüsse gekoppelt. So kann der elektrische Antrieb 10 mit Gleichstrom versorgt werden, der dann vom Umrichter 11 in einen Wechselstrom gewandelt wird, um letztlich die Phasenstromzweige der elektrischen Maschine 12 mit Wechselstrom zu versorgen. Zur Versorgung mit Strom weist der elektrische Antrieb 10 innerhalb des Gehäuses 15 weitere elektrisch leitfähige Leiter auf, die in den Zeichnungen nicht dargestellt sind und welche die elektrisch leitfähige Verbindung zwischen den Bauteilen des elektrischen Antriebs 10 sicherstellen.

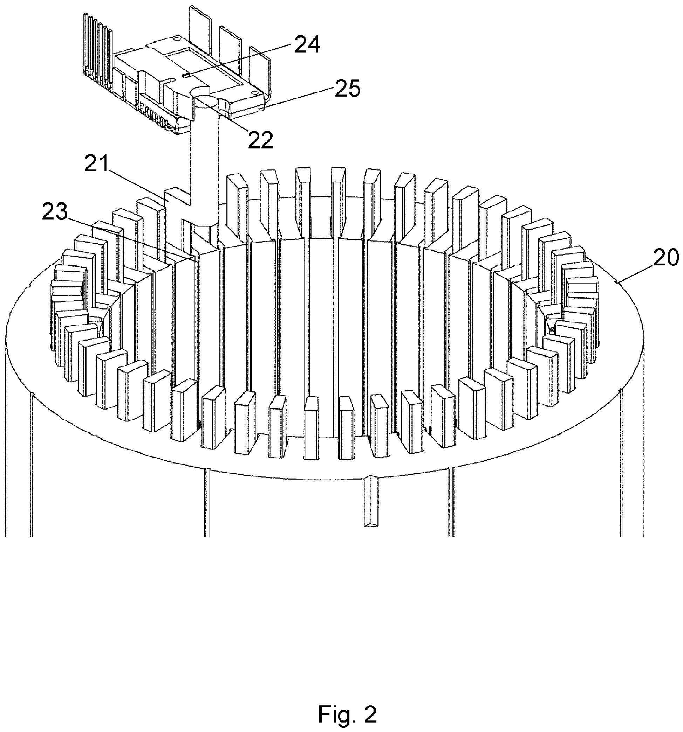

Fig. 2 zeigt einen Teil eines Stators 20 einer elektrischen Maschine 12 eines elektrischen Antriebs 10 mit einem Phasenanschluss 22 eines Phasenstromzweigs in einer perspektivischen Ansicht. Der Stator 20 mit den in Fig. 2 dargestellten Bauteilen kann im Gehäuse 15, wie in Fig. 1 dargestellt, angeordnet sein. Er kann jedoch auch in jedem anderen Gehäuse eines elektrischen Antriebs angeordnet sein. Der Stator 20 besteht aus Metall und kann in Form eines Metallblechlaminats hergestellt sein, ist hierauf aber nicht beschränkt. Der Stator umfasst eine Nut 23 in welcher der Nutstab 21 angeordnet ist. Wie in Fig. 2 dargestellt, weist der Stator jedoch eine Vielzahl von Nutstäben und Nuten auf. Der Nutstab 23 bildet einen Teil eines Phasenstromzweiges, der durch den Phasenanschluss 22 an stromversorgende Bauteile eines Umrichters 11 angeschlossen ist. Dabei ist der Phasenanschluss ein Teil des Nutstabes 21, der aus der Nut herausgeführt ist und der sich durch verschiedene weitere Elemente des elektrischen Antriebs 10 hindurch erstreckt, welche in Fig. 2 nicht dargestellt sind. So ist durch den Phasenanschluss 22 eine elektrische Kopplung des Nutstabs 21 mit dem Umrichter 11 möglich.

Der Nutstab 21 ist als massives Metallbauteil ausgeführt. Dadurch weist er eine hohe Steifigkeit und Robustheit auf. Auch der Phasenanschluss 22 ist als massives Metallbauteil ausgeführt, das in seiner Querschnittsfläche im Wesentlichen dem Querschnitt des Nutstabs 21 entspricht und das somit eine mindestens gleich hohe Steifigkeit und Robustheit aufweist wie der Nutstab 21. Durch eine solche massive Ausgestaltung kann neben einer erhöhten Langlebigkeit dieser Bauteile zudem sichergestellt werden, dass der Phasenanschluss 22 mindestens genauso resistent gegenüber Einwirkungen von Beschleunigungen durch Vibrationen oder Bewegungen durch den Betrieb des elektrischen Antriebs 10 ist wie der Nutstab 21. Dies ermöglicht, dass sich der Abstand zwischen dem Phasenanschluss 22 und einem Magnetfeld-Sensor, der zur Messung des Phasenstroms, den der Phasenanschluss 22 führt, verwendet wird nicht oder nur sehr geringfügig verändert, wodurch die Messgenauigkeit erhöht und Messfehler aufgrund einer Abstandsveränderung zwischen Phasenanschluss 22 und einem Magnetfeld-Sensor vermindert werden können. Obwohl der Phasenanschluss 22 in Fig. 2 als zur Rotationsachse des Rotors der elektrischen Maschine 12 hin versetzt angeordnet dargestellt ist, kann der Phasenanschluss 22 auch in direkter Verlängerung zum Nutstab 21, das heißt zum Nutstab 21 nicht versetzt, oder aber auch vom Nutstab 21 ausgehend in eine andere Richtung hin versetzt angeordnet sein. Der seitliche oder laterale Versatz oder Abstand ist dabei auch frei wählbar, um den Erfordernissen des Aufbaus des elektrischen Antriebs 10 zu entsprechen.

Der Phasenanschluss 22 verfügt in einer in Fig. 2 dargestellten Ausführungsform zudem über einen seitlich oder lateral von der Rotationsachse des Rotors des elektrischen Antriebs 10 ausgehend versetzten Abschnitt. Dieser Abschnitt des Phasenanschlusses 22 verläuft innerhalb einer Ebene, in welcher eine Normale der Rotationsachse verläuft. Somit verläuft und erstreckt sich der Phasenanschluss 22 zumindest teilweise, und zwar in Form des seitlich oder lateral versetzten Abschnittes, in einer Ebene, in der auch eine Normale einer Rotationsachse des Rotors des elektrischen Antriebs 10 verläuft. Der Phasenanschluss kann jedoch auch hiervon abweichend angeordnet und ausgebildet sein. Außerdem kann der Phasenanschluss 22 auch innerhalb dieser Ebene von der Richtung der Normalen weg gekrümmt, zum Beispiel wie ein Schaufelrad radial nach außen verlaufend gekrümmt, ausgebildet sein. Wesentlich ist lediglich, dass der Phasenanschluss 22 die elektrische Kopplung des Nutstabs 21 mit dem Umrichter 11 sicherstellt und dass er über die vorab beschriebene notwendige Robustheit und Steifigkeit verfügt, um Einflüsse von Vibrationen oder Bewegungen auf die Position des Phasenanschlusses 22 zu minimieren.

Zudem muss der Phasenanschluss 22 über eine Krümmung 24 verfügen. Durch eine Krümmung des Phasenanschlusses 22 wird die Fokussierung des Magnetfeldes, das durch den Phasenstrom, den der Phasenanschluss leitet, erzeugt wird, erreicht. Dadurch kann auch mit einem magnetkernlosen Magnetfeld-Sensor, der im Bereich der Krümmung 24 angeordnet ist, eine Durchsetzung des Magnetfeld-Sensors mit einem deutlich stärkeren Magnetfeld erreicht werden. Dieses Messprinzip basiert darauf, dass der Strom durch die Krümmung 24 auf eine teilweise Kreisbahn gezwungen wird. Entsprechend dem Biot-Savart-Gesetz für eine Leiterschleife führt dies zu einer Verstärkung des Magnetfeldes um den Faktor π, das heißt um mehr als das 3-fache. Zusätzlich zur reinen Verstärkung des Signals führt dies aber auch zur Verbesserung des Signal-zu-Rausch-Verhältnisses, da durch die Krümmung 24 nur das zu messende Signal gegenüber dem magnetkernlosen Sensor, der im Bereich der Krümmung 24 angeordnet ist, und nicht auch die Störsignale anderer magnetischer Felder, wie denen benachbarter Phasenanschlüsse, verstärkt wird. Durch die Krümmung 24 kann somit die Messgenauigkeit bedeutend erhöht werden ohne dass es der Verwendung eines Magnetkerns bedarf, was mit Kosten-, Platz- und Gewichtsersparnissen einhergeht.

In einer Ausführungsform der Erfindung umfasst der elektrische Antrieb 10 in der elektrischen Maschine 12 zwölf Phasenstromzweige mit denen die Nutstäbe des Stators 20 versorgt werden. Somit weist nicht jeder einzelne Nutstab zwangsläufig auch einen eigenen Phasenanschluss, wie den Phasenanschluss 22 des Nutstabs 21 in Fig. 2, auf. Stattdessen können mehrere Stäbe untereinander und am Stator miteinander gekoppelt sein, wodurch ein Phasenanschluss zur Stromversorgung mehrerer Nutstäbe des Stators dienen kann. So könnte die Nutstabzahl, wie in Fig. 2 dargestellt, 48 betragen und diese 48 Nutstäbe können durch zwölf Phasenanschlüsse, wovon nur einer in Fig. 2 dargestellt ist, mit Strom versorgt werden, sodass jeweils vier Nutstäbe des Stators pro Phasenanschluss miteinander verschaltet sind. Diese miteinander verschalteten Nutstäbe und der dazugehörige Phasenanschluss bilden dann einen Phasenstromzweig im Sinne der vorliegenden Anmeldung. Die Anzahl der Nutstäbe und der Phasenstromzweige oder Phasenanschlüsse kann von der hier angegeben Anzahl jedoch abweichen, ohne dass die vorliegende Erfindung dadurch negativ beeinflusst wird, um den elektrischen Antrieb auf seine jeweilig vorgesehene Verwendung anzupassen und um ihn entsprechend optimieren zu können.

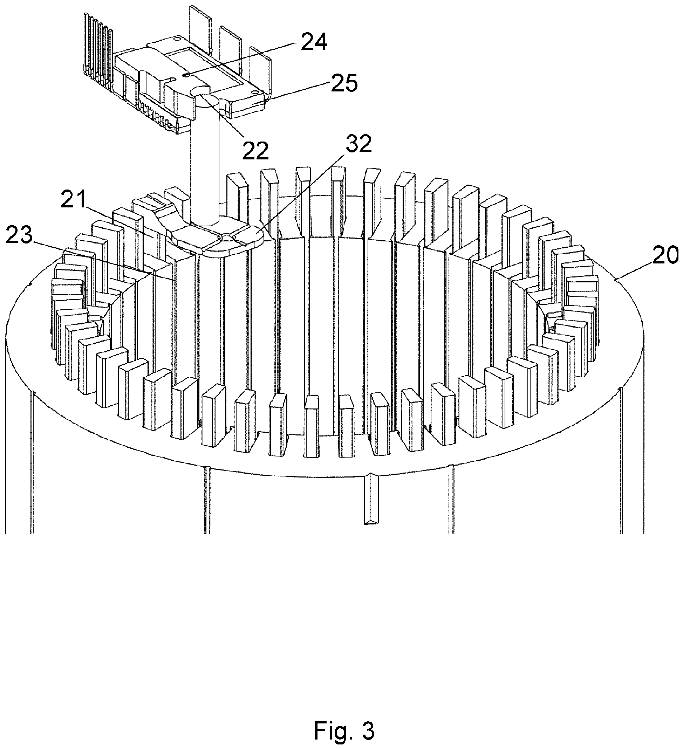

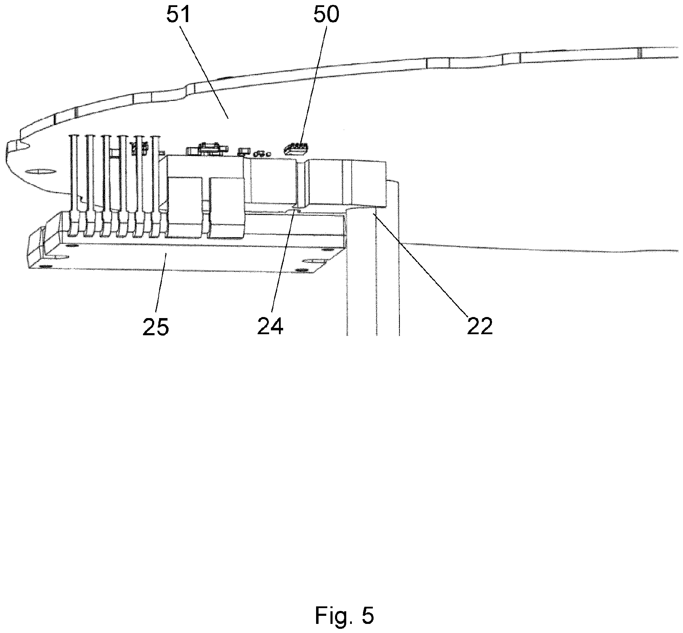

In Fig. 2 ist der Abschnitt des Phasenanschlusses 22, der seitlich/lateral von der Rotationsachse des Rotors des elektrischen Antriebs 10 ausgehend versetzt ist und der sich innerhalb einer Ebene erstreckt, in welcher eine Normale der Rotationsachse verläuft, als auf einer Baugruppe 25 bestehend aus mehreren Halbleiterschaltern angeordnet dargestellt. Die Halbleiterschalter sind ihrerseits über elektrisch leitfähige Verbindungen, die sich in Fig. 2 auf der rechten Seite der Baugruppe 25 als nach oben gebogen verlaufend dargestellt sind, mit der Stromversorgung des elektrischen Antriebs 10 gekoppelt. Die auf der linken Seite der Baugruppe 25 angeordneten und nach oben gebogen verlaufend dargestellten Anschlüsse dienen dem Anschluss der Halbleiterschalter an die elektronischen Bauteile des Umrichters 11, welche den Umrichter 11 steuern. Die Halbleiterschalter der Baugruppe 25 verrichten die Umrichtung des durch die Stromversorgung eingespeisten Gleichstroms hin zu dem Wechselstrom mit welchem der Phasenanschluss 22 versorgt wird. Dabei wird die Stromzufuhr, wie zuvor hinsichtlich Fig. 1 beschrieben, durch die Kabel 14 und die Anschlussbox 13 des elektrischen Antriebs 10 geleistet. In einer Ausführungsform der vorliegenden Erfindung wird der Phasenanschluss 22 durch Halbleiterschalter des Umrichters 11 mit Wechselstrom versorgt. Insbesondere kann der Umrichter 11 über eine Platine, die in Fig. 2 nicht dargestellt ist und welche die zur Steuerung des Umrichters 11 erforderlichen elektronischen Bauteile trägt, umfassen. Die seitlich versetzte Ausführung des Phasenanschlusses inklusive der somit seitlich versetzt angeordneten Krümmung 24 des Phasenanschlusses 22 ist in einer so ausgeführten Umrichterarchitektur vorteilhaft, weil dieser Abschnitt des Phasenanschlusses 22 somit zumindest teilweise parallel zu einer Ebene von weiteren elektronischen Bauteilen des Umrichters 11 verläuft, wie der Platine 51, die hinsichtlich Fig. 5 weiter erläutert wird. Insbesondere kann auf der Platine des Umrichters 11 auch der magnetkernlose Magnetfeld-Sensor zur Phasenstrommessung angebracht sein. Durch eine solche Anordnung kann sich automatisch auch eine Anordnung des Sensors ergeben, durch die der magnetische Fluss im Wesentlichen senkrecht auf eine Messfläche des Sensors auftritt. Allerdings kann von dieser Ausführungsform auch abgewichen werden, wenn die Umrichterarchitektur von der hier beschriebenen Anordnung der Platine 51 des Umrichters 11 abweicht, was je nach Anforderungen an Baugröße und Leistung des elektrischen Antriebs 10 möglich ist. Außerdem kann von dieser Anordnung auch abgewichen werden, wenn die Krümmung an einer anderen Stelle des Phasenanschlusses 22 angeordnet ist. So kann der mindestens eine magnetkernlose Magnetfeld-Sensor 50 auch auf einer Platine zur Strommessung angeordnet sein (nicht in den Figs. dargestellt), die eine signalübertragende Verbindung zu einer Platine zur Steuerung des Umrichters 11 aufweist. In dieser Ausführungsform ist der Sensor 50 nicht auf der Platine 51 zur Steuerung des Umrichters 11 angeordnet und der Sensor 50 kann mit der Platine zur Strommessung an einem beliebigen Ort des elektrischen Antriebs angeordnet werden, zum Beispiel an einem flexiblen Abschnitt 32. Eine solche abweichende Variante wird nachfolgend hinsichtlich Fig. 3 weiter erläutert.

Fig. 3 zeigt einen Teil eines Stators 20 eines elektrischen Antriebs 10 mit einem Phasenanschluss 22 in einer perspektivischen Ansicht. Anders als in der Ausführungsform, die in Fig. 2 dargestellt und die vorhergehend beschrieben ist, weist der Phasenanschluss 22 nach einer Ausführungsform, die in Fig. 3 dargestellt ist, jedoch einen flexiblen Abschnitt 32 auf, welcher selbst gekrümmt ist und der somit eine Krümmung darstellt und der den Phasenanschluss 22 mit einem Nutstab 21 verbindet, der zumindest teilweise in einer Nut des Stators 20 der elektrischen Maschine 12 angeordnet ist. Die weiteren Elemente, die in Fig. 3 dargestellt sind, sind zu denen in Fig. 2 identisch, weshalb diese Elemente nachfolgend nicht erneut beschrieben werden. Dementsprechend ist der flexible Abschnitt 32 des Phasenanschlusses 22 optional zur Ausführungsform wie hinsichtlich Fig. 2 beschrieben hinzufügbar oder aus der Ausführungsform nach Fig. 3 entfernbar. Der flexible Abschnitt 32 dient der zusätzlichen mechanischen Entkopplung des Phasenanschlusses 22, um die Auswirkungen von Vibrationen oder Bewegungen auf die Position des Phasenanschlusses 22 zu minimieren. Beim Betrieb der elektrischen Maschine 12 können durch den Betrieb verursachte Bewegungen insbesondere in der Richtung der Rotationsachse des Rotors zu stärkeren mechanischen Spannungen führen. Deshalb kann der flexible Abschnitt 32 mindestens in die Richtung, entlang welcher die Rotationsachse des Rotors der elektrischen Maschine 12 verläuft, mechanisch flexibel sein, um mechanische Spannungen, die zumindest in Richtung der Rotationsachse auftreten, ausgleichen zu können. Dadurch kann sichergestellt werden, dass sich ein Abstand zwischen dem Phasenanschluss 22 und einem zur Messung des Phasenstroms vorgesehenen magnetkernlosen Magnetfeld-Sensor nicht oder nur sehr geringfügig ändert, wodurch wie bereits vorhergehend beschrieben Messfehler vermieden werden können.

Der flexible Abschnitt 32 des Phasenanschlusses 22 ist wie in Fig. 3 abgebildet so gestaltet, dass er eine Verlängerung des Nutstabs 21 außerhalb der Nut bildet, welche eine U-Form aufweist. Mit anderen Worten verläuft der flexible Abschnitt gekrümmt, wobei die gekrümmte Form insgesamt einen Winkel von etwa 180° bildet, wobei der Winkel hiervon abweichen kann und nicht darauf festgelegt ist. Aufgrund dieser Form weist der flexible Abschnitt eine höhere, federartige Verformbarkeit auf, welche zu der zuvor beschriebenen Minimierung von durch Vibrationen oder Bewegungen verursachten Positionsveränderungen des Phasenanschlusses 22 beiträgt. Der flexible Abschnitt 32 kann, aber muss nicht als eigenständiges Bauteil ausgeführt sein und kann ein integraler Bestandteil des Phasenanschlusses 22 sein. Des Weiteren hat die gekrümmte Form des flexiblen Abschnitts 32 dieselbe Wirkung wie die Krümmung 24 des Phasenabschnitts 22. Durch den gebogenen Verlauf des Leiterabschnitts des Phasenanschlusses 22, der dem flexiblen Abschnitt 32 entspricht, wird der Strom auf eine teilweise Kreisbahn gezwungen. Entsprechend dem Biot-Savart-Gesetz für eine Leiterschleife führt dies zu einer Verstärkung des Magnetfeldes um den Faktor π, das heißt um mehr als das 3-fache. Hierdurch wird nochmals verdeutlicht, dass auch die Krümmung 24 keine Verjüngung, wie in Fig. 2 und Fig. 3 abgebildet, sondern lediglich eine Form des Phasenanschlusses 22 darstellen muss, welche den Leiter so verändert, dass der Strom zumindest teilweise auf einen kreisbahnförmigen Verlauf gezwungen wird. Der flexible Abschnitt 32 des Phasenanschlusses 22 kann somit genau wie die Krümmung 24 als geeignete Stelle für die Messung des Phasenstroms dienen an der ein magnetkernloser Magnetfeld-Sensor den Strom mit geringen Messfehlern bestimmen kann.

Dementsprechend kann der magnetkernlose Magnetfeld-Sensor in sämtlichen Ausführungsformen der vorliegenden Erfindung auch am oder im Bereich des flexiblen Abschnitts 32 angebracht werden, der selbst eine Krümmung darstellt. Es wäre dann nicht notwendig einen weiteren Sensor an der Krümmung 24 anzubringen und auf die Ausgestaltung des Phasenanschlusses mit der Krümmung 24 kann dann verzichtet werden. Jedoch kann die Krümmung 24, wie in Fig. 3 abgebildet, auch trotz des flexiblen Abschnitts 32 weiterhin Teil des Phasenanschlusses 22 sein, sodass auch ein Anbringen von jeweils einem magnetkernlosen Magnetfeld-Sensor an oder bei dem flexiblen Abschnitt 32 sowie der Krümmung 24 möglich ist, was zur Erhöhung der Redundanz und Ausfallsicherheit führt. Wie vorhergehend bereits beschrieben, kann der mindestens eine magnetkernlose Magnetfeld-Sensor 50 in diesem Fall auf einer separaten, das heißt auf einer zusätzlichen Strommessplatine angeordnet sein, die sich von der Platine 51 zur Steuerung des Umrichters 11 unterscheidet. Eine solche separate Strommessplatine kann eine signalübertragende Verbindung aufweisen, über welche Daten, die der Sensor erzeugt, an die Platine 51 zur Steuerung des Umrichters 11 übertragen werden können. Bei dieser Verbindung kann es sich um eine drahtlose Verbindung oder um eine bedrahtete Verbindung, das heißt um eine Verbindung mit einem oder mehreren elektrischen Leitern handeln. Durch diese Ausführungsform führt zu einer größeren Flexibilität bei der Gestaltung des elektrischen Antriebs 10, wodurch der Aufbau nach den Bedürfnissen der Platzersparnis in verschiedenen Teilen des elektrischen Antriebs 10 optimierbar ist. Hierdurch ergibt sich insbesondere bei Systemen mit einer hohen Phasenstromzweiganzahl eine bedeutende platzersparende Komponente, da dann nicht nur ein Sensor, sondern eine der Phasenstromzweiganzahl entsprechende Anzahl von Sensoren an beliebigen anderen Stellen des mindestens einen Phasenanschlusses 22 mit einer Krümmung angeordnet werden können an denen mehr Platz für die Sensoren vorhanden ist.

Somit erfordert die vorliegende Erfindung, dass der Phasenanschluss über eine an irgendeiner Stelle des Phasenanschlusses angeordnete Krümmung, beispielsweise in Form einer Verjüngung, oder in Form einer Biegung, aufweist, wodurch wie vorhergehend erläutert die Verstärkung des magnetischen Flusses erreicht wird. Ob diese Krümmung an einem seitlich/lateral versetzten Abschnitt des Phasenanschlusses 22 wie in Fig. 2 dargestellt, oder an einem gebogenen flexiblen Abschnitt 33 des Phasenanschlusses 32 wie in Fig. 3 dargestellt, oder davon weitergehend abweichend an sonst einer anderen Stelle eines möglicherweise anders gestalteten Phasenanschlusses angeordnet ist, ist dabei nicht maßgeblich, so lang die die Erfordernisse hinsichtlich der Robustheit und somit hinsichtlich der Vibrations- und Bewegungsunanfälligkeit, der Platzersparnis und der Fokussierung des Magnetfeldes des Phasenanschlusses gemäß der vorhergehenden Beschreibung erfüllt sind.

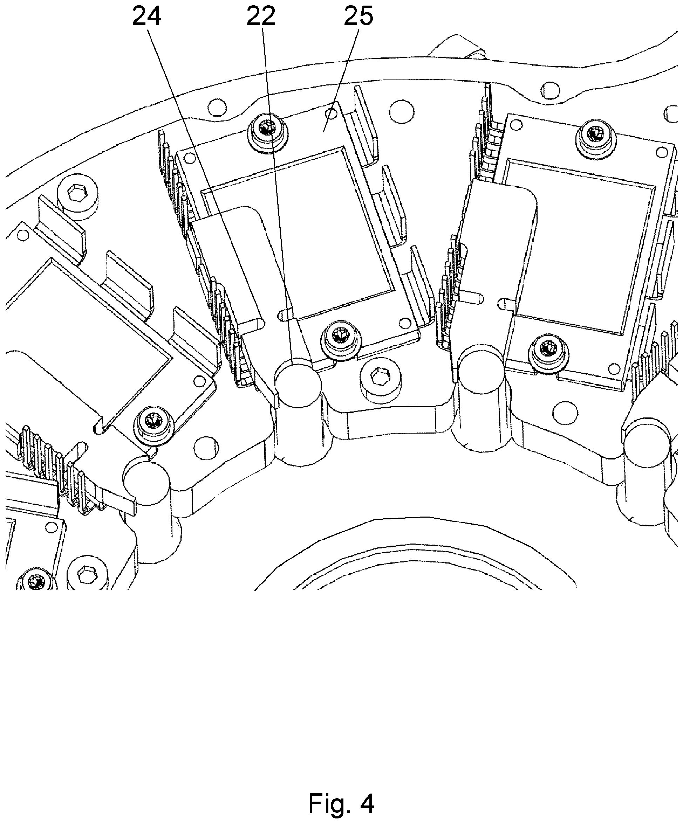

Fig. 4 zeigt einen Teil eines Umrichters 11 eines elektrischen Antriebs 10 mit einem Phasenanschluss 22 in einer perspektivischen Ansicht. In Fig. 4 sind weitere Teile des elektrischen Antriebs 10, die in Fig. 2 oder Fig. 3 nicht abgebildet sind, zu sehen. So wird der Phasenanschluss 22 durch verschiedene Ebenen des Umrichters geführt. Hierfür können in diesen Ebenen Öffnungen vorgesehen sein, durch welche der Phasenanschluss 22 verläuft. Demnach kann der Phasenanschluss durch einen Raum solcher Öffnungen verlaufen. Zur zusätzlichen mechanischen Stabilisierung und um Auswirkungen von Vibrationen oder Bewegungen auf die Position des Phasenanschlusses 22 weiter zu minimieren, kann ein O-Ring den Phasenanschluss 22 umschließen, sodass ein Raum, der sich um den Phasenanschluss herum befindet und durch den der Phasenanschluss 22 sich erstreckt, in zwei Teilräume geteilt wird, da der O-Ring an den Wänden des Raums anliegt. Der O-Ring dient somit auch als ringförmiges Dichtungselement und kann die beiden Teilräume fluiddicht voneinander trennen. Hierdurch wird ein Austausch von Gasen zwischen der elektrischen Maschine 12 und dem Umrichter 11 verhindert, was für die Funktion des elektrischen Antriebs 10 von Vorteil ist, da dies die Sicherheit des elektrischen Antriebs 10 erhöhen kann. Darüber hinaus kann mindestens ein Teilraum mit einem Verguss gefüllt werden, es können somit auch alle Teilräume mit einem Verguss gefüllt werden. Der Verguss kann thermisch leitend und elektrisch isolierend sein und kann eine thermische Kopplung mit einem Lagerschild des elektrischen Antriebs herstellen. Das Lagerschild kann ein Teil oder eine Ebene der nicht in Fig. 4 dargestellten Elemente des elektrischen Antriebs 10 sein, durch deren Öffnung sich der Phasenanschluss 22 erstreckt. Durch die thermische Kopplung des Phasenanschlusses 22 mit dem Lagerschild kann ein Abführen von Wärme aus dem Phasenanschluss 22 in das Lagerschild und somit eine Kühlung des Phasenanschlusses 22 erreicht werden. Dazu kann das Lagerschild auch passiv oder aktiv gekühlt sein, oder es kann lediglich als Wärmepuffer dienen. Dies kann zusätzlich zur Minimierung der Einflüsse von Vibrationen oder Bewegungen auf die Position des Phasenanschlusses 22 auch thermische Ausdehnungen und durch diese Ausdehnung bedingte geringfügige Positionsveränderungen des Phasenanschlusses 22 reduzieren, wodurch die Messgenauigkeit des magnetkernlosen Magnetfeld-Sensors weiter erhöht werden kann. Zudem bewirkt der Verguss eine weitergehende mechanische Fixierung des Phasenanschlusses 22 in den Öffnungen bzw. dem Raum durch den der Phasenanschluss 22 sich erstreckt.

Alternativ oder zusätzlich zur thermischen Kopplung mit dem Lagerschild eines elektrischen Antriebs 10 kann der Verguss zudem eine thermische Kopplung zu einem Kühlkörper des elektrischen Antriebs herstellen. In dieser Ausführungsform ist die thermische Kopplung durch den Verguss identisch zur oben beschriebenen Form der thermischen Kopplung mit einem Lagerschild gestaltet, sodass die vorhergehenden Aspekte ebenso für den Kühlkörper gelten können, durch dessen Öffnung sich der Phasenanschluss 22 entsprechend erstrecken kann. Sowohl bei der thermischen Kopplung des Phasenanschlusses 22 durch den Verguss mit dem Lagerschild oder mit dem Kühlkörper ist nicht zwingend erforderlich, dass der Phasenanschluss 22 durch eine tunnelförmige Öffnung geführt ist. Stattdessen ist erforderlich, dass der Phasenanschluss zumindest teilweise entlang einer Oberfläche des Lagerschildes oder des Kühlkörpers verläuft, sodass eine Kontaktoberfläche als Schnittstelle zur Wärmeübertragung zwischen diesen Komponenten vorhanden ist, womit automatisch eine gewisse mechanische Fixierung einhergeht.

Obwohl vorhergehend von einem Verguss die Rede ist, muss der Verguss nicht zwangsläufig durch Gießen eines oben beschriebenen Materials hergestellt werden. Der Verguss kann auch durch andere geeignete Herstellungsverfahren hergestellt werden, durch die eine thermische Kopplung, wie vorhergehend beschrieben, zwischen dem Phasenanschluss 22 und dem Lagerschild und/oder dem Kühlkörper erreicht werden kann.

Zudem ist in Fig. 4 zu sehen, dass neben einem Phasenanschluss 22 und einer Baugruppe 25 weitere solche Phasenanschlüsse und Baugruppen benachbart angeordnet sein können, um weitere Phasenstromzweige des elektrischen Antriebs zu versorgen, wie vorhergehend beschrieben. Des Weiteren ist die Krümmung 24 des Phasenanschlusses 22 aus einer anderen Perspektive abgebildet. Somit wird der gekrümmte Verlauf des Phasenanschlusses 22 an der Krümmung 24 besser erkennbar, der in dieser Ausführungsform auf sowohl der linken also auch rechten Seite vorgesehen ist und der somit als eine Verjüngung des Phasenanschlusses 22 ausgebildet sein kann. Von dieser Ausführungsform abweichend können die Halbleiterschalter der Baugruppe 25 jedoch auch an einer anderen Stelle des Umrichters 11 angeordnet sein. Ebenso kann, wie vorhergehend beschrieben, der Phasenanschluss 22 anders ausgebildet sein und eine Krümmung an einer anderen Stelle aufweisen. In einer Ausführungsform ist über der in Fig. 4 dargestellten Ebene eine weitere Ebene des Umrichters 11 angeordnet, welche eine Platine umfasst, wie in Fig. 5 dargestellt.

Fig. 5 zeigt einen Teil eines Umrichters 11 eines elektrischen Antriebs 10 mit einem Phasenanschluss 22 in einer perspektivischen Ansicht. In einer Ausführungsform kann der Umrichter 11 über eine Platine 51 verfügen, wie vorhergehend beschrieben. Auf dieser Platine können elektronische Bauteile, die zur Steuerung des Umrichters 11 dienen, angeordnet sein. Zudem kann auf der Platine 51 ein magnetkernloser Magnetfeld-Sensor 50 angeordnet sein. In einer Ausführungsform kann der Sensor oberhalb der Krümmung 24 auf der Platine 51 angeordnet sein. Dadurch befindet sich der Sensor im Bereich der Krümmung 24, sodass dieser das durch die Krümmung 24 verstärkte Magnetfeld des Phasenanschlusses 22 messen kann. Wie in Fig. 5 abgebildet, kann der magnetkernlose Magnetfeld-Sensor 50 als ein oberflächenmontiertes Bauteil, auch als SMD oder surface mounted device bezeichnet, gestaltet sein, welches als integrierte Schaltung in einem eigenen Gehäuse auf der Platine 51 angeordnet ist. Ein solches oberflächenmontiertes Bauteil kann in der Herstellung vollautomatisch auf der Platine 51 angebracht werden, was zur Zeit- und Kostenersparnis bei der Herstellung führt. Der magnetkernlose Magnetfeld-Sensor 50 kann jedoch auch als bedrahtetes elektronisches Bauteil gestaltet sein, welches als integrierte Schaltung in einem eigenen Gehäuse auf der Platine 51 angeordnet ist. Ein solches bedrahtetes elektronisches Bauteil kann durch Einsteckmontage, auch als Durchsteckmontage oder through-hole-Technik bezeichnet, auf der Platine 51 angeordnet werden, was jedoch aufwändiger und kostenintensiver ist als bei einem oberflächenmontierten Bauteil.

Die Verwendung eines magnetkernlosen Magnetfeld-Sensors 50 auf der Platine 51 vereinfacht den Aufbau gegenüber einem magnetkernbehafteten Magnetfeld-Sensor, da außer der einfachen Montage des Sensors auf der Platine 51 keine weitere Verdrahtung und keine weitere Anbindung nötig ist, die von dem Sensor wegführt. Außer der einen physischen Verbindung zur Platine, worunter die mechanische und elektrische Verbindung des Sensors an die Platine mittels einem oder mittels mehrerer physischer Kontakte, wie Kontaktpins oder Drähten, zu verstehen ist, umfasst ein solcher Sensor folglich keine weiteren Anschlüsse oder Verbindungen. Insbesondere umfasst ein solcher Sensor keine physische Verbindung, die den Sensor mit einem Magnetkern koppelt. Hierdurch können Verluste, die sonst an weiteren Anschlüssen, Verbindungen oder Bauteilen anfallen würden, vermieden werden, wodurch die Systemeffizienz vorteilhaft steigt.

Unabhängig davon, ob der magnetkernlose Magnetfeld-Sensor 50 ein oberflächenmontiertes oder bedrahtetes elektronisches Bauteil ist, kann der Sensor ein Sensor nach einem der folgenden Typen darstellen, die dem Fachmann geläufig sind. So kann es sich um einen Hall-Sensor und/oder um einen Closed-Loop-Sensor oder einen Open-Loop-Sensor und/oder um eines von einem magnetoresistiven Sensor, einem anisotropen magnetoresistiven Effekt, AMR, Sensor, einem Riesenmagnetowiderstand, GMR, Sensor, einem magnetischen Tunnelwiderstand, TMR, Sensor oder einem colossal magnetic resistance, CMR, Sensor handeln. Diese Liste ist nicht als einschränkend zu verstehen, sondern soll lediglich der Verdeutlichung dienen welche Arten von Sensoren für den Einsatz als magnetkernloser Magnetfeld-Sensor 50 in Frage kommen.

Neben einem Magnetfeld-Sensor kann der elektrische Antrieb 10 auch mindestens einen Beschleunigungssensor umfassen, der zur Messung von Vibrationen oder Bewegungen, denen der elektrische Antrieb 10 ausgesetzt wird, verwendet werden kann.

In einer Ausführungsform kann der Umrichter 11 eine Architektur mit mindestens drei Ebenen aufweisen, die orthogonal zu der Rotationsachse des Rotors der elektrischen Maschine verlaufen und die in Richtung der Rotationsachse zueinander versetzt angeordnet sind. Dabei kann der Umrichter 11 eine erste Ebene umfassen, wobei auf der ersten Ebene eine Platine 51 zur Steuerung des Umrichters 11 angeordnet ist, wie in Fig. 5 dargestellt. In einer Ausführungsform kann der mindestens eine magnetkernlose Magnetfeld-Sensor 50 auf dieser Platine angeordnet sein. In einer Ausführungsform kann der Umrichter 11 zudem eine zweite Ebene aufweisen, wobei auf der zweiten Ebene mindestens ein Halbleiterschalter des Umrichters 11 angeordnet ist. Auf der zweiten Ebene kann also die Baugruppe 25 angeordnet sein. So kann auch der Abschnitt des Phasenanschlusses 22, der sich zumindest teilweise in einer Ebene erstreckt, in der die Normale der Rotationsachse verläuft, auf der zweiten Ebene angeordnet sein. In einer Ausführungsform kann der Umrichter 11 eine dritte Ebene aufweisen, wobei auf der dritten Ebene mindestens ein Kühlkörper zur Kühlung der Halbleiterschalter angeordnet ist. Zudem kann die dritte Ebene einen Gleichstromanschluss mit einem Minuspol aufweisen und die zweite Ebene kann einen Gleichspannungsanschluss mit einem Pluspol aufweisen. Über diese Pole kann die Versorgung des Umrichters 11 mit Gleichstrom erfolgen.

Zudem kann der Umrichter 11 alternativ eine vierte Ebene aufweisen, wobei die vierte Ebene einen Gleichspannungsanschluss aufweist, der sowohl aus einem Pluspol als auch einem Minuspol besteht, wobei der Abschnitt des Phasenanschlusses 22, der sich zumindest teilweise in einer Ebene erstreckt, in der die Normale der Rotationsachse verläuft, dann auch auf der vierten Ebene angeordnet ist. Zudem kann die vierte Ebene den Abschnitt des Phasenanschlusses 22, der sich zumindest teilweise in einer Ebene erstreckt, in der die Normale der Rotationsachse verläuft, auf der vierten Ebene angeordnet umfassen. Dann kann die dritte Ebene einen Gleichspannungsanschluss mit einem Minuspol umfassen und die zweite Ebene einen Gleichspannungsanschluss mit einem Pluspol. Wie vorhergehend beschrieben, kann der magnetkernlose Magnetfeld-Sensor 50 sowohl auf der Platine 51 zur Steuerung des Umrichters 11, als auch auf einer Platine zur Strommessung, die eine datenübertragende Verbindung mit der Platine 51 zur Steuerung des Umrichters 11 aufweist. Demnach kann der magnetkernlose Magnetfeld-Sensor 50 auf einer vorhergehend beschriebenen Ebene des Umrichters 11 angeordnet sein, die die Platine 51 umfasst, oder der Magnetfeld-Sensor 50 kann außerhalb einer der Ebenen des Umrichters 11 angeordnet sein. Somit kann der elektrische Antrieb auch mehr Platinen als nur die Platine 51 umfassen.

Abweichend hiervon können die Elemente, die vorhergehend als auf einer der drei oder vier Ebenen angeordnet beschrieben sind, jedoch auf lediglich zwei oder auch nur einer Ebene angeordnet sein. Dies ermöglicht eine besonders kompakte Umrichterarchitektur. Zur Reduktion der Ebenen können Aussparungen in den verwendeten Bauteilen und Komponenten, oder mehrschichtige, das heißt übereinander verlaufend angeordnete Komponenten, verwendet werden. Die genaue Umrichterarchitektur ist für die vorliegende Erfindung jedoch nicht maßgeblich, sodass die hier beschriebenen und in Figs. 4 und 5 dargestellten Varianten lediglich der Erläuterung dienen.

Obwohl die vorhergehende Beschreibung meist von einem magnetkernlosen Magnetfeld-Sensor 50 spricht, kann auch mehr als ein magnetkernloser Magnetfeld-Sensor 50 im elektrischen Antrieb 10 verwendet werden. Zum einen deshalb, weil der elektrische Antrieb 10, wie beschrieben, über mehrere Phasenstromzweige und Phasenanschlüsse verfügen kann. Zum anderen deshalb, weil jeder Phasenanschluss über mehrere Krümmungen verfügen kann, an denen jeweils ein magnetkernloser Magnetfeld-Sensor 50 angebracht werden kann.

### Bezugszeichenliste:

- 10: Elektrischer Antrieb
- 11: Umrichter
- 12: Elektrische Maschine
- 13: Anschlussbox
- 14: Kabel
- 15: Gehäuse
- 16: Motormantel
- 20: Stator
- 21: Nutstab
- 22: Phasenanschluss
- 23: Nut
- 24: Krümmung
- 25: Baugruppe
- 32: flexibler Abschnitt
- 50: magnetkernloser Magnetfeld-Sensor
- 51: Platine

## Patentansprüche

1. Elektrischer Antrieb (10), umfassend:
- einen Umrichter (11);
- eine elektrische Maschine (12), die eine Vielzahl von Phasenstromzweigen umfasst, wobei die elektrische Maschine (12) und der Umrichter (11) gemeinsam in einem Gehäuse (15) angeordnet sind; und
- mindestens einen magnetkernlosen Magnetfeld-Sensor (50) zum Messen eines Stroms von mindestens einem der Vielzahl von Phasenstromzweigen;
**dadurch gekennzeichnet, dass**
- mindestens ein Phasenstromzweig der Vielzahl von Phasenstromzweigen einen Nutstab (21) umfasst, der zumindest teilweise in einer Nut (23) der elektrischen Maschine (12) angeordnet ist und der außerhalb der Nut (23) einen Phasenanschluss (22) bildet; und
- der Phasenanschluss (22) eine Krümmung (24, 32) aufweist in deren Bereich der mindestens eine magnetkernlose Magnetfeld-Sensor (50) angeordnet ist.

2. Elektrischer Antrieb nach Anspruch 1, wobei der Phasenanschluss (22) zumindest teilweise in einer Ebene normal zu einer Rotationsachse eines Rotors des elektrischen Antriebs (10) verläuft; und/oder
wobei der Phasenanschluss (22) von einer Richtung normal zu der Rotationsachse innerhalb der Ebene weg gekrümmt ist.

3. Elektrischer Antrieb (10) nach einem der vorhergehenden Ansprüche, wobei der mindestens eine magnetkernlose Magnetfeld-Sensor (50) auf einer Platine (51) angeordnet ist.

4. Elektrischer Antrieb (10) nach Anspruch 3, wobei der mindestens eine magnetkernlose Magnetfeld-Sensor (50) ausschließlich eine physische Verbindung aufweist, die aus einem oder mehreren physischen Kontakten besteht; und
wobei die eine physische Verbindung den mindestens einen magnetkernlosen Magnetfeld-Sensor (50) ausschließlich mit der Platine (51) verbindet.

5. Elektrischer Antrieb (10) nach einem der Ansprüche 3 und 4, wobei
der mindestens eine magnetkernlose Magnetfeld-Sensor (50) aus einem oberflächenmontierten Bauteil besteht, das als integrierte Schaltung in einem eigenen Gehäuse auf der Platine (51) angeordnet ist; oder
der mindestens eine magnetkernlose Magnetfeld-Sensor (50) aus einem bedrahteten Bauteil besteht, das als integrierte Schaltung in einem eigenen Gehäuse auf der Platine (51) angeordnet ist.

6. Elektrischer Antrieb (10) nach einem der Ansprüche 3 bis 5, wobei der Phasenanschluss (22) zumindest teilweise parallel zu einer Ebene verläuft, auf der die Platine (51) angeordnet ist.

7. Elektrischer Antrieb (10) nach einem der Ansprüche 3 bis 6, wobei die Platine (51) eine Platine zur Steuerung des Umrichters (11) ist.

8. Elektrischer Antrieb (10) nach einem der Ansprüche 3 bis 5, wobei die Platine eine Platine zur Strommessung ist, die eine signalübertragende Verbindung zu einer Platine (51) zur Steuerung des Umrichters (11) aufweist.

9. Elektrischer Antrieb (10) nach einem der vorhergehenden Ansprüche, wobei der mindestens eine magnetkernlose Magnetfeld-Sensor (50) ein Hall-Sensor und/oder eines von einem Closed-Loop-Sensor oder einem Open-Loop-Sensor und/oder eines von einem magnetoresistiven Sensor, einem anisotropen magnetoresistiven Effekt, AMR, Sensor, einem Riesenmagnetowiderstand, GMR, Sensor, einem magnetischen Tunnelwiderstand, TMR, Sensor oder einem colossal magnetic resistance, CMR, Sensor ist.

10. Elektrischer Antrieb (10) nach einem der vorhergehenden Ansprüche, wobei der Phasenanschluss (22) ferner einen flexiblen Abschnitt (32) mit einer gekrümmten Form aufweist, der den Phasenanschluss (22) mit dem Teil des Nutstabs (21) verbindet, der zumindest teilweise in der Nut (23) der elektrischen Maschine (12) angeordnet ist und der mindestens in eine Richtung einer Rotationsachse eines Rotors der elektrischen Maschine (12) mechanisch flexibel ist, um mechanische Spannungen, die zumindest in Richtung der Rotationsachse auftreten, ausgleichen zu können.

11. Elektrischer Antrieb (10) nach Anspruch 10, wobei der mindestens eine magnetkernlose Magnetfeld-Sensor (50) zum Messen des Stroms von mindestens einem der Vielzahl von Phasenstromzweigen bei dem flexiblen Abschnitt (32) und im Bereich der gekrümmten Form des flexiblen Abschnitts (32) angeordnet ist.

12. Elektrischer Antrieb (10) nach einem der Ansprüche 10 und 11, wobei der flexible Abschnitt (32) orthogonal zur Richtung der Rotationsachse verläuft und wobei die gekrümmte Form des flexiblen Abschnitts (32) eine U-Form aufweist.

13. Elektrischer Antrieb (10) nach einem der vorhergehenden Ansprüche, wobei ein O-Ring den Phasenanschluss (22) umschließt und einen Raum, der sich um den Phasenanschluss (22) herum befindet, in zwei Teilräume teilt und diese voneinander fluiddicht trennt.

14. Elektrischer Antrieb (10) nach Anspruch 13, wobei
mindestens einer der Teilräume mit einem Verguss gefüllt ist; und
der Verguss thermisch leitend und elektrisch isolierend ist; und
der Verguss thermisch mit einem Lagerschild und/oder einem Kühlkörper des elektrischen Antriebs (10) gekoppelt ist.

15. Elektrischer Antrieb (10) nach einem der vorhergehenden Ansprüche, wobei der elektrische Antrieb (10) zusätzlich einen Beschleunigungssensor umfasst.

## Claims

1. An electric drive (10) comprising:
- an inverter (11);
- an electric machine (12) comprising a plurality of phase current branches, wherein the electric machine (12) and the inverter (11) are arranged together in a housing (15); and
- at least one magnetic field sensor (50) without a magnetic core for measuring a current of at least one of the plurality of phase current branches;
**characterized in that**
at least one phase current branch of the plurality of phase current branches comprises a slot bar (21) which is arranged at least partially in a slot (23) of the electric machine (12) and which forms a phase terminal (22) outside the slot (23); and
the phase terminal (22) has a curvature (24, 32) in the region of which the at least one magnetic field sensor (50) without a magnetic core is arranged.

2. Electric drive according to claim 1, wherein the phase terminal (22) extends at least partially in a plane normal to an axis of rotation of a rotor of the electric drive (10); and/or
wherein the phase terminal (22) is curved away from a direction normal to the axis of rotation within the plane.

3. Electric drive (10) according to one of the preceding claims, wherein the at least one magnetic field sensor (50) without a magnetic core is arranged on a circuit board (51).

4. Electric drive (10) according to claim 3, wherein the at least one magnetic field sensor (50) without a magnetic core has only one physical connection which consists of one or more physical contacts; and
wherein the one physical connection connects the at least one magnetic field sensor (50) without a magnetic core only to the circuit board (51).

5. Electric drive (10) according to one of claims 3 and 4, wherein
the at least one magnetic field sensor (50) without a magnetic core consists of a surface-mounted component which is arranged as an integrated circuit in a separate housing on the circuit board (51); or
the at least one magnetic field sensor (50) without a magnetic core consists of a wired component which is arranged as an integrated circuit in a separate housing on the circuit board (51).

6. Electric drive (10) according to one of claims 3 to 5, wherein the phase terminal (22) extends at least partially parallel to a plane on which the circuit board (51) is arranged.

7. Electric drive (10) according to one of claims 3 to 6, wherein the circuit board (51) is a circuit board for controlling the converter (11).

8. Electric drive (10) according to one of claims 3 to 5, wherein the circuit board is a circuit board for current measurement which has a signal-transmitting connection to a circuit board (51) for controlling the converter (11).

9. Electric drive (10) according to one of the preceding claims, wherein the at least one magnetic field sensor (50) without a magnetic core is a Hall sensor and/or one of a closed-loop sensor or an open-loop sensor and/or one of a magnetoresistive sensor, an anisotropic magnetoresistive effect, AMR, sensor, a giant magnetoresistance, GMR, sensor, a magnetic tunnel resistance, TMR, sensor or a colossal magnetic resistance, CMR, sensor.

10. Electric drive (10) according to one of the preceding claims, wherein the phase terminal (22) further comprises a flexible portion (32) with a curved shape which connects the phase terminal (22) to the part of the slot bar (21) which is arranged at least partially in the slot (23) of the electric machine (12) and which is mechanically flexible at least in a direction of an axis of rotation of a rotor of the electric machine (12) in order to be able to compensate mechanical stresses occurring at least in the direction of the axis of rotation.

11. Electric drive (10) according to claim 10, wherein the at least one magnetic field sensor (50) without a magnetic core for measuring the current of at least one of the plurality of phase current branches is arranged at the flexible portion (32) and in the region of the curved shape of the flexible portion (32).

12. Electric drive (10) according to one of claims 10 and 11, wherein the flexible portion (32) extends orthogonally to the direction of the axis of rotation and wherein the curved shape of the flexible portion (32) has a U-shape.

13. Electric drive (10) according to one of the preceding claims, wherein an O-ring encloses the phase terminal (22) and divides a space located around the phase terminal (22) into two sub-spaces and separates them from each other in a fluid-tight manner.

14. Electric drive (10) according to claim 13, wherein
at least one of the sub-spaces is filled with a casting; and
the casting is thermally conductive and electrically insulating; and
the casting is thermally coupled to a bearing shield and/or a heat sink of the electric drive (10).

15. Electric drive (10) according to one of the preceding claims, wherein the electric drive (10) additionally comprises an acceleration sensor.

## Revendications

1. Moteur électrique (10), comprenant :
- un convertisseur (11) ;
- une machine électrique (12), qui comprend une pluralité de branches de courant phasé, dans lequel la machine électrique (12) et le convertisseur (11) sont disposés ensemble dans un boîtier (15) ; et
- au moins un capteur de champ magnétique sans noyau magnétique (50), pour mesurer un courant d'au moins une de la pluralité de branches de courant phasé ;
**caractérisé en ce que**
- au moins une branche de courant phasé de la pluralité de branches de courant phasé comprend une tige de rainure (21), qui est disposée au moins partiellement dans une rainure (23) de la machine électrique (12) et qui forme une connexion de phase (22) à l'extérieur de la rainure (23) ; et
- la connexion de phase (22) présente une courbure (24, 32) dans la zone où est disposé l'au moins un capteur de champ magnétique sans noyau magnétique (50).

2. Moteur électrique selon la revendication 1, dans lequel la connexion de phase (22) s'étend au moins partiellement dans un plan normal à un axe de rotation d'un rotor du moteur électrique (10) ; et/ou
dans lequel la connexion de phase (22) est courbée en s'écartant d'une direction normale à l'axe de rotation à l'intérieur du plan.

3. Moteur électrique (10) selon l'une des revendications précédentes, dans lequel l'au moins un capteur de champ magnétique sans noyau magnétique (50) est disposé sur une platine (51).

4. Moteur électrique (10) selon la revendication 3, dans lequel l'au moins un capteur de champ magnétique sans noyau magnétique (50) possède une liaison exclusivement physique qui est constituée d'un ou de plusieurs contacts physiques ; et
dans lequel la une liaison exclusivement physique relie l'au moins un capteur de champ magnétique sans noyau magnétique (50) à la platine (51).

5. Moteur électrique (10) selon l'une des revendications 3 et 4, dans lequel l'au moins un capteur de champ magnétique sans noyau magnétique (50) est constitué d'un composant monté en surface qui est monté sur la platine (51) dans un boîtier propre en tant que circuit intégré ; ou
l'au moins un capteur de champ magnétique sans noyau magnétique (50) est constitué d'un composant câblé qui est monté sur la platine (51) dans un boîtier propre en tant que circuit intégré.

6. Moteur électrique (10) selon l'une des revendications 3 à 5, dans lequel la connexion de phase (22) s'étend au moins partiellement parallèlement à un plan sur lequel est disposée la platine (51).

7. Moteur électrique (10) selon l'une des revendications 3 à 6, dans lequel la platine (51) est une platine de commande du convertisseur (11).

8. Moteur électrique (10) selon l'une des revendications 3 à 5, dans lequel la platine est une platine de mesure de courant qui présente une liaison de transmission de signal vers une platine (51) de commande du convertisseur (11).

9. Moteur électrique (10) selon l'une des revendications précédentes, dans lequel l'au moins un capteur de champ magnétique sans noyau magnétique (50) est un capteur à effet Hall et/ou l'un d'entre un capteur en boucle fermée ou un capteur en boucle ouverte, et/ou l'un d'entre un capteur magnétorésistif, un capteur à effet magnétorésistif anisotrope, AMR, un capteur à magnétorésistance géante, GMR, un capteur à magnétorésistance tunnel, TMR, ou un capteur à magnétorésistance colossale, CMR.

10. Moteur électrique (10) selon l'une des revendications précédentes, dans lequel la connexion de phase (22) présente en outre une section flexible (32) avec une forme courbée qui relie la connexion de phase (22) à la partie de la tige de rainure (21) qui est disposée au moins partiellement dans la rainure (23) de la machine électrique (12) et qui est mécaniquement flexible au moins dans une direction d'un axe de rotation d'un rotor de la machine électrique (12), pour compenser les contraintes mécaniques qui se produisent au moins en direction de l'axe de rotation.

11. Moteur électrique (10) selon la revendication 10, dans lequel l'au moins un capteur de champ magnétique sans noyau magnétique (50) est agencé pour mesurer le courant d'au moins l'une de la pluralité de branches de courant phasé pour la section flexible (32) et dans la zone de la forme courbée de la section flexible (32).

12. Moteur électrique (10) selon l'une des revendications 10 et 11, dans lequel la section flexible (32) s'étend perpendiculairement à la direction de l'axe de rotation et dans lequel la forme courbée de la section flexible (32) présente une forme en U.

13. Moteur électrique (10) selon l'une des revendications précédentes, dans lequel un joint torique entoure la connexion de phase (22) et divise un espace qui se trouve autour de la connexion de phase (22) en deux espaces partiels et sépare ceux-ci l'un de l'autre de manière étanche aux fluides.

14. Moteur électrique (10) selon la revendication 13, dans lequel
au moins un des espaces partiels est rempli d'un matériau de scellement ; et
le matériau de scellement est thermoconducteur et électriquement isolant ; et
le matériau de scellement est couplé thermiquement à un flasque et/ou à un dissipateur thermique du moteur électrique (10).

15. Moteur électrique (10) selon l'une des revendications précédentes, dans lequel le moteur électrique (10) comprend en outre un capteur d'accélération.
